# EUROPÄISCHE PATENTSCHRIFT

(11) **EP 0 776 087 B1**
(45) Veröffentlichungstag und Bekanntmachung des Hinweises auf die Patenterteilung: **30.05.2001**
(21) Anmeldenummer: 96112599.4
(22) Anmeldetag: 03.08.1996
(51) Int. Cl.: H03F 1/02

(54) **CMOS-Transkonduktanzverstärker mit gleitendem Arbeitspunkt**
CMOS transconductance amplifier with dynamic biasing
Amplificateur CMOS de transconductance avec polarisation glissante

(30) Priorität: 24.11.1995 DE 19543866
(43) Veröffentlichungstag der Anmeldung: 28.05.1997
(73) Patentinhaber: Micronas GmbH, 79108 Freiburg (DE)
(72) Erfinder: Theus, Ulrich, Dr.-Ing., 79194 Gundelfingen (DE); Besemann, Michael, 79108 Freiburg (DE)

(56) Entgegenhaltungen:
- EP-A- 0 491 980
- US-A- 5 451 902
- IEEE JOURNAL OF SOLID-STATE CIRCUITS, Bd. sc-17, Nr. 6, Dezember 1982, USA, Seiten 1080-1087, XP002026331 ALLSTOT: "A Precision Variable-Supply CMOS Comparator"

## Beschreibung

Die Erfindung betrifft einen CMOS-Transkonduktanzverstärker mit gleitendem Arbeitspunkt, mit einem Spannungs/Stromumsetzer, der einen Differenzeingang für eine Eingangsspannung u, einen Stromspeisepunkt S, dem von einer Konstantstromquelle ein Ruhestrom I₀ zugeführt ist, und an dessen ersten Ausgang C ein erstes und an dessen zweiten Ausgang B ein zweites Lastelement angeschlossen ist, wobei das erste Lastelement den Eingang einer ersten Stromspiegelschaltung und das zweite Lastelement den Eingang einer zweiten Stromspiegelschaltung bilden, und ein erster Ausgang der ersten Stromspiegelschaltung und ein erster Ausgang der zweiten Stromspiegelschaltung so mit einem Ausgangsknotenpunkt A verbunden sind, daß sich dort die Ausgangsstromanteile I_{L1}, I_{L2} gegenphasig überlagern, daß ein zweiter Ausgang der ersten Stromspiegelschaltung über einen ersten Mitkopplungszweig und ein zweiter Ausgang der zweiten Stromspiegelschaltung über einen zweiten Mitkopplungszweig mit dem Stromspeisepunkt S so verbunden sind, daß der jeweilige Mitkopplungsstrom I_{M1}, I_{M2} der Mitkopplungszweige dem Ruhestrom I₀ positiv überlagert wird.

Ein solcher Transkonduktanzverstärker ist aus IEEE Journal of Solid State Circuits, Vol. SC-17, 1982, S. 1080 - 1087 bekannt. Er ist zum Treiben großer kapazitiver Lasten gut geeignet. Da er einen gleitenden Arbeitspunkt hat, kann im Ruhezustand des Verstärkers eine geringe Stromaufnahme erreicht werden. Es kann somit eine geringe Ruhestromaufnahme und eine hohe Stromergiebigkeit des Ausgangs bewirkt werden. Aufgrund der von den Stromspiegelschaltungen ausgehenden Mittkopplungszweigen und des symmetrischen Aufbaus für beide Lastrichtungen weist der Transkonduktanzverstärker einen gleitenden Arbeitspunkt auf, der einen Laststrom in beide Stromrichtungen ermöglicht.

Der Erfindung liegt die Aufgabe zugrunde, einen Transkonduktanzverstärker mit gleitendem Arbeitspunkt zu schaffen, der einen Laststrom in beiden Richtungen ermöglicht und bei dem die laststromunabhängige Eigenstromaufnahme reduziert wird.

Diese Aufgabe wird dadurch gelöst, daß bei dem gattungsgemäßen Transkonduktanzverstärker parallel zu dem ersten Lastelement die Source/Drain-Strecke eines erster Transistors und parallel zu dem zweiten Lastelement die Source/Drain-Strecke eines zweiten Transistors geschaltet ist, wobei der Gateanschluß des ersten Transistors mit dem zweiten Ausgang und der Gateanschluß des zweiten Transistors mit dem ersten Ausgang des Spannungs/Stromumsetzers verbunden ist.

Die erfindungsgemäße Kreuzkopplung der Lastelemente mit dem ersten und zweiten Transistor bewirkt eine Reduzierung des Stromes durch die Lastelemente, da sich der Strom hinter den beiden Schaltungspunkten B, C, an denen das erste Lastelement mit dem ersten Transistor und das zweite Lastelement mit dem zweiten Transistor verbunden sind, in je zwei Teilstöme durch das jeweilige Lastelement und den jeweiligen Transistor aufteilt. Diese Aufteilung ist abhängig von der Differenzspannung am Eingang des Spannungs/Stromumsetzers. Dadurch werden auch die Ströme aller Ausgänge der ersten und der zweiten Stromspiegelschaltung reduziert. In der Ruhelage des Transkonduktanzverstärkers, d.h. wenn die Eingangsspannung u am Differenzeingang gleich Null ist, fließt somit in der gesamten Schaltung weniger Strom.

Befindet sich die Schaltung nicht in der Ruhelage, so daß eine von Null verschiedene Eingangsspannung u am Differenzeingang anliegt, so sind auch die Ströme, die durch die beiden Lastelemente und die beiden Teile der Schaltung fließen, unterschiedlich groß. In dem Fall, in dem der Strom in dem zweiten Zweig des Differenzeingangs größer ist als in dessen ersten Zweig, fließt ein größerer Strom durch den zweiten Schaltungspunkt B als durch den ersten Schaltungspunkt C. Damit fließt ein größerer Strom durch das zweite Lastelement. Mit dem zunehmenden Strom durch das zweite Lastelement wird der Strom, der durch den ersten Transistor fließt, größer, da dieser durch die Ansteuerung des Gates von dem Ausgang des Spannungs/Stromumsetzers niederohmiger wird. Als Folge davon fließt weniger Strom von dem Schaltungspunkt C durch das erste Lastelement. Hierdurch wird auch der Strom, der von dem ersten Ausgang des ersten Stromspiegels zu dem Ausgangsknotenpunkt A fließt, vermindert. Dadurch wird erreicht, daß die Stromdifferenz am Ausgangsknotenpunkt größer ist, so daß der dort zur Verfügung stehende Nutzstrom zunimmt. Die entsprechende Wirkung wird erziehlt, wenn eine Eingangsspannung mit entgegengesetzter Polung vorliegt. Die Begründung läßt sich dabei auf den jeweils entgegengesetzten Zweig übertragen.

Dadurch wird auch die Gesamtsteilheit der Schaltung, d.h. das Verhältnis der Differenz der Ausgangsströme der beiden Zweige zu der Eingangsspannung u, vergrößert.

Gemäß einem bevorzugten Ausführungsbeispiel der Erfindung weisen die Lastelemente der Differenzeingangsstufe je einen als Diode geschalteten Transistor auf, die vom gleichen Typ wie der erste und der zweite Transistor sind. Das W/L-Verhältnis des ersten Transistors ist dabei vorteilhafterweise kleiner als das W/L-Verhältnis des ersten Lasttransistors und das W/L-Verhältnis des zweiten Transistors kleiner als das W/L-Verhältnis des zweiten Lasttransistors. So wird gewährleistet, daß die kreuzgekoppelte Schaltung keine Latch-Schaltung bildet, so daß die Linearität der Schaltung erhalten bleibt.

Gemäß einer weiteren Ausbildung der Erfindung ist ein dritter Ausgang der ersten Stromspiegelschaltung über einen ersten Kopplungszweig mit dem zweiten Ausgang der zweiten Stromspiegelschaltung in einem Schaltungspunkt K1 und ein dritter Ausgang der zweiten Stromspiegelschaltung über einen zweiten Kopplungszweig mit dem zweiten Ausgang der ersten Stromspiegelschaltung in einem Schaltungspunkt K2 so verbunden, daß sich die Ströme des zweiten Mitkopplungszweiges und des ersten Kopplungszweiges sowie des ersten Mitkopplungszweiges und des zweiten Kopplungszweiges dort subtraktiv überlagern. Hierdurch wird erreicht, daß in dem Fall, in dem die Eingangsspannung u des Differenzeingangs Null beträgt, wobei die Ströme in den beiden Zweigen der Schaltung gleich groß sind, kein zusätzlicher Strom in den Schaltungspunkt S eingespeist wird.

Dabei können die Mitkopplungszweige und die Kopplungszweige je eine Stromspiegelschaltung aufweisen. Die erste und die zweite Stromspiegelschaltung können Feldeffekttransistoren eines ersten Leitungstyps und die dritte Stromspiegelschaltung, sowie der erste und zweite Mitkopplungszweig sowie der erste und zweite Kopplungszweig Feldeffekttransistoren eines zweiten zu dem ersten entgegengesetzten Leitungstyps aufweisen. Die Stromspiegelschaltungen des ersten Mitkopplungszweigs und des zweiten Kopplungszweiges sowie des zweiten Mitkopplungszweiges und des ersten Kopplungszweiges wirken jeweils als Subtraktor. Die Dimensionierung der Transistoren dieser Stromspiegelschaltungen kann so gewählt werden, daß der zu den Schaltungspunkten K2 und K1 fließende Strom gleich Null ist. Daraus ergibt sich, daß der zu dem Schaltungspunkt S fließende Strom in der Ruhelage der Schaltung gleich Null ist. Dann fließt nur der konstante Ruhestrom I₀ durch den Schaltungspunkt S.

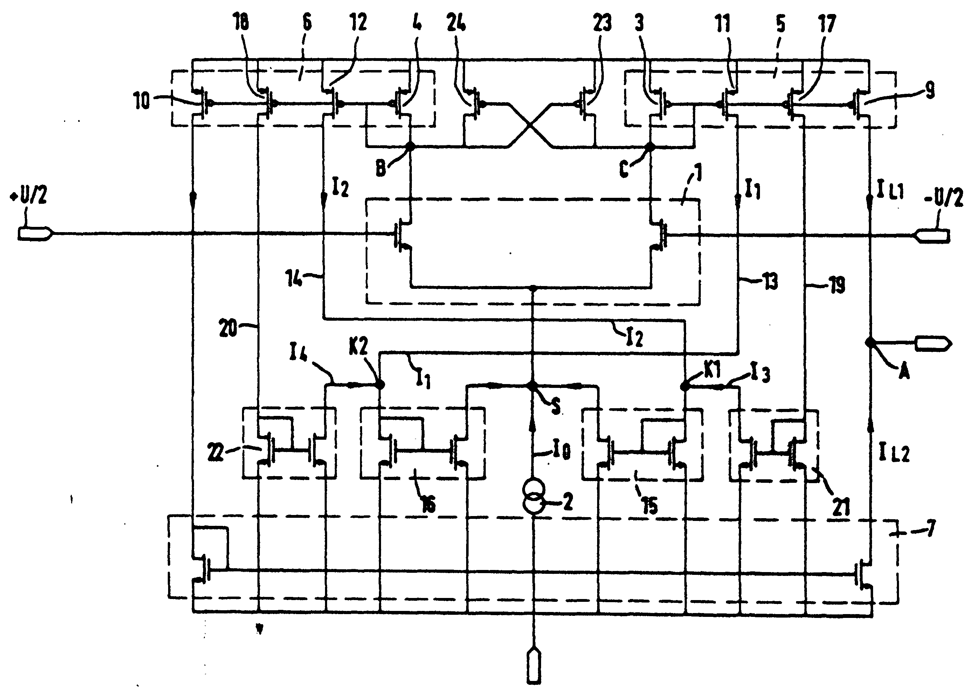

Im folgenden wird die Erfindung anhand der Figur näher erläutert.

Die Figur zeigt ein erfindungsgemäßes Ausführungsbeispiel eines CMOS-Transkonduktanzverstärkers.

Der gezeigte CMOS-Transkonduktanzverstärker weist einen Spannungs/Stromumsetzer auf, der einen Differenzeingang 1 für eine Eingangsspannung u hat, wobei einem Stromspeisepunkt S ein Ruhestrom I₀ von einer Konstantstromquelle 2 zugeführt ist. Im gezeigten Ausführungsbeispiel sind die Eingänge der Differenzeingangsstufe n-Kanal-Transistoren. Es wird darauf hingewiesen, daß die Anordnung von n-Kanal- und p-Kanal-Transistoren nur ein Ausführungsbeispiel ist und n-Kanal- und p-Kanal-Transistoren auch durchgehend gegeneinander ausgetauscht werden können.

Der Spannungs/Stromumsetzer weist zwei Lastelemente 3, 4 auf, die hier jeweils aus einem p-Kanal-Transistor bestehen. Das erste Lastelement 3 ist über eine erste Stromspiegelschaltung 5 mit einem Ausgangsknotenpunkt A verbunden. Das zweite Lastelement 4 ist über eine zweite Stromspiegelschaltung 6 und eine dritte Stromspiegelschaltung 7 ebenfalls mit dem Ausgangsknotenpunkt A verbunden. Der aus dem ersten Ausgang 9 der ersten Stromspiegelschaltung 5 ausgekoppelte Stromanteil I₁ und der aus dem ersten Ausgang 10 der zweiten und dritten Stromspiegelschaltung 6, 7 ausgekoppelte Stromanteil I₂ überlagern sich im Ausgangsknoten A gegenphasig, so daß dort die Differenz dieser Ströme gebildet wird.

Ein zweiter Ausgang 11 der ersten Stromspiegelschaltung 5 ist über einen ersten Mitkopplungszweig 13 mit dem Stromspeisepunkt S so verbunden, daß sich ein Teil des Stroms I₁ dort dem Ruhestrom I₀ positiv überlagert. In dazu symmetrischer Ausbildung ist ein zweiter Ausgang 12 der zweiten Stromspiegelschaltung 6 über einen zweiten Mitkopplungszweig 14 mit dem Stromspeisepunkt S so verbunden, daß sich ein Teil des Stroms I₂ dem Ruhestrom I₀ positiv überlagert. Für das Einkoppeln der Ströme I₁, I₂ in den Stromspeisepunkt S ist in dem ersten Mitkopplungszweig 13 ein Stromspiegel 15 und in dem zweiten Mitkopplungszweig 14 ein Stromspiegel 16 aus n-Kanal-Transistoren vorgesehen. Von einem dritten Ausgang 17 der ersten Stromspiegelschaltung 5 wird über einen ersten Kopplungszweig 19 ein Strom I₃ und über einen dritten Ausgang 18 der zweiten Stromspiegelschaltung 6 ein Strom I₄ dem zweiten Ausgang 11 der zweiten Stromspiegelschaltung 6 bzw. dem zweiten Ausgang 12 der ersten Stromspiegelschaltung 5 so zugeführt, daß sich die Ströme I₃, I₂ des zweiten Mitkopplungszweiges 14 und des ersten Kopplungszweiges 19 in dem Schaltungspunkt K1 und des ersten Mitkopplungszweiges 13 und des zweiten Kopplungszweiges 20 in dem Schaltungspunkt K2 subtraktiv überlagern. Dabei werden die Ströme I₃, I₄ über Stromspiegel 21, 22 aus n-Kanal-Transistoren geführt. Ist die Eingangsspannung u gleich Null, so wird, wenn die Dimensionierung der Transistoren so gewählt ist, daß der Strom I₁ bzw. I₂ in der Ruhelage der Schaltung gleich dem Strom I₄ bzw. I₃ ist, kein zusätzlicher Strom in den Stromspeisepunkt S eingespeist, da der Ausgangsstrom der Stromspiegelschaltung 16 bzw. 15 gleich Null ist. Damit fließt in der Ruhelage nur der Strom I₀ durch den Stromspeisepunkt S.

Bei einer Differenzspannung u ungleich Null wird dem Stromspeispunkt S von einem der beiden Ausgänge der Stromspiegelschaltungen 15 oder 16 ein zusätzlicher Speisestrom zugeführt. Dieser Speisestrom ist abhängig von der Differenz-Eingangsspannung. Hierdurch wird der gleitende Arbeitspunkt der Schaltung realisiert. Die Symmetrie der Schaltung sorgt dafür, daß das Prinzip des gleitenden Arbeitspunktes für Differenzspannungen beider Vorzeichen gewährleistet ist.

Parallel zu dem als Diode geschalteten, das erste Lastelement 3 bildenden p-Kanal-Transistor ist ein erster Transistor 23, ebenfalls ein p-Kanal-Transistor, geschaltet, dessen Gate von der Ausgangsspannung des das zweite Lastelement 4 bildenden p-Kanal-Transistor angesteuert wird. Parallel zu dem zweiten Lastelement 4 ist ein zweiter p-Kanal-Transistor 24 geschaltet, dessen Gate von der Ausgangsspannung des ersten Lastelements 3 angesteuert wird. Hierdurch entsteht eine Kreuzkopplung.

Die Differenzansteuerung im Spannungs/Stromumsetzer führt zu unterschiedlichen Spannungen in den Schaltungspunkten B und C. Wegen der Ansteuerung des ersten und des zweiten Transistors durch die unterschiedlichen Spannungen an den Knoten A und B werden die Stromanteile, die von den Strömen B und C durch die Lasttransistoren fließen, für den einen Lasttransistor vergrößert und für den anderen verringert.

Im folgenden wird die Funktionsweise des erfindungsgemäßen Transkonduktanzverstärkers für den Fall beschrieben, daß der Transkonduktanzverstärker als Spannungsfolgerschaltung verwendet wird. Im unbelasteten Zustand der Schaltung sind die Ströme am Ausgang der Stromspiegelschaltungen 15, 16 gleich Null, so daß dem Strom I₀ der Konstantstromquelle 2 kein Mitkopplungsstrom überlagert wird. Im belasteten Zustand des Transkonduktanzverstärkers in diesem Anwendungsbeispiel führt der Laststrom an dem Ausgangsknotenpunkt A zu einer Differenzspannung u am Eingang des Spannungs/Stromumsetzers. Damit sind die zu den Schaltungspunkten B und C fließenden Ströme unterschiedlich groß. Dadurch ändern sich die Spannungen an den Lastelementen 3 und 4, die als Dioden geschaltet sind. Hinter den Schaltungspunkten B, C teilen sich diese Ströme unterschiedlich auf. Für den Fall, daß der Strom durch den Schaltungspunkt B kleiner ist als der Strom durch den Schaltungspunkt C, wird der Betrag der Spannung an dem Lastelement 4 kleiner als der Betrag der Spannung an dem Lastelement 3. Aufgrund der Kreuzkopplung wird der Transistor 24 weiter ausgesteuert als der als Lastelement 4 dienende Transistor, so daß der Stromanteil durch den Transistor 24 größer wird, wohingegen der Stromanteil durch das Lastelement 4 kleiner wird. Für den Fall, daß der Strom I₁ durch den ersten Mitkopplungszweig 13 größer ist als der Strom I₄ durch den zweiten Kopplungszweig 20, entsteht aufgrund der subtraktiven Überlagerung in dem Schaltungspunkt K2 ein Differenzstrom, der als zusätzlicher Strom in den Schaltungspunkt S eingespeist wird. Infolge der Kreuzkopplung der Lastelemente 3, 4 mit den Transistoren 23, 24 wird der Strom in dem Kopplungszweig 20 erniedrigt, wodurch der Differenzstrom, der in den Schaltungspunkt S fließt, vergrößert wird. Der Strom in den weiteren Schaltungsteilen, der nicht zum Nutzstrom beiträgt, wird kleiner. Es wird auch der Stromanteil I_{L2} kleiner, so daß der Laststrom des Transkonduktanzverstärkers I_{L1} - I_{L2} im Ausgangsknotenpunkt A größer wird. Es wird aufgrund der erfindungsgemäßen Anordnung das Verhältnis von Eigenstromaufnahme zur Nutzstromabgabe der Schaltung verbessert. Zudem wird die Steilheit des Transkonduktanzverstärkers erhöht.

## Patentansprüche

1. CMOS-Transkonduktanzverstärker mit gleitendem Arbeitspunkt,
mit einem Spannungs/Stromumsetzer, der einen Differenzeingang (1) für eine Eingangsspannung (u), einen Stromspeisepunkt S, dem von einer Konstantstromquelle (2) ein Ruhestrom I₀ zugeführt ist, und an dessen ersten Ausgang C ein erstes Lastelement (3) und an dessen zweiten Ausgang B ein zweites Lastelement (4) angeschlossen ist, wobei das erste Lastelement (3) den Eingang einer ersten Stromspiegelschaltung (5) und das zweite Lastelement (4) den Eingang einer zweiten Stromspiegelschaltung (6) bilden, und ein erster Ausgang (9) der ersten Stromspiegelschaltung (5) und ein erster Ausgang (10) der zweiten Stromspiegelschaltung (6) so mit einem Ausgangsknotenpunkt A verbunden sind,
daß sich dort die Ausgangsstromanteile (I_{L1}, I_{L2}) gegenphasig überlagern,
daß ein zweiter Ausgang (11) der ersten Stromspiegelschaltung (5) über einen ersten Mitkopplungszeig (13) und ein zweiter Ausgang (12) der zweiten Stromspiegelschaltung (6) über einen zweiten Mitkopplungszweig (14) mit dem Stromspeisepunkt S so verbunden sind, daß der jeweilige Strom (I₁, I₂) der Mitkopplungszweige (13, 14) dem Ruhestrom (I₀) positiv überlagert wird,
dadurch gekennzeichnet,
daß parallel zu dem ersten Lastelement (3) die Source/Drain-Strecke eines erster Transistors (23) und parallel zu dem zweiten Lastelement (4) die Source/Drain-Strecke eines zweiten Transistors (24) geschaltet ist, wobei der Gateanschluß des ersten Transistors (23) mit dem zweiten Ausgang B und der Gateanschluß des zweiten Transistors (24) mit dem ersten Ausgang C des Spannungs/Stromumsetzers verbunden ist.

2. Transkonduktanzverstärker nach Anspruch 1, dadurch gekennzeichnet, daß die Lastelemente (3, 4) je einen als Diode geschalteten Lasttransistor aufweisen, die vom gleichen Typ wie der erste und der zweite Transistor (23, 24) sind.

3. Transkonduktanzverstärker nach Anspruch 2, dadurch gekennzeichnet, daß das W/L-Verhältnis des ersten Transistors (23) kleiner als das W/L- Verhältnis des ersten Lasttransistors (3) und das W/L-Verhältnis des zweiten Transistors (24) kleiner als das W/L-Verhältnis des zweiten Lasttransistors (4) ist.

4. Transkonduktanzverstärker nach einem der vorangehenden Ansprüche, dadurch gekennzeichnet, daß ein dritter Ausgang (17) der ersten Stromspiegelschaltung (5) über einen ersten Kopplungszweig (19) mit dem zweiten Ausgang der zweiten Stromspiegelschaltung (6) in einem Schaltungspunkt K1 und ein dritter Ausgang (18) der zweiten Stromspiegelschaltung (6) über einen zweiten Kopplungszweig (20) mit dem zweiten Ausgang (17) der ersten Stromspiegelschaltung (5) in einem Schaltungspunkt K2 so verbunden sind, daß sich die Ströme des zweiten Mitkopplungszweigs (14) und des ersten Kopplungszweiges (19) sowie des ersten Mitkopplungszweiges (13) und des zweiten Kopplungszweiges (20) subtraktiv überlagern.

5. Transkonduktanzverstärker nach einem der vorangehenden Ansprüche, dadurch gekennzeichnet, daß die Mitkopplungszweige (13, 14) und der Kopplungszweige (19, 20) jeweils eine Stromspiegelschaltung aufweisen.

6. Transkonduktanzverstärker nach einem der vorangehenden Ansprüche, dadurch gekennzeichnet, daß der erste Ausgang (10) der zweiten Stromspiegelschaltung (6) über eine dritte Stromspiegelschaltung (7) mit dem Ausgangsknotenpunkt A verbunden ist.

7. Transkonduktanzverstärker nach einem der vorangehenden Ansprüche, dadurch gekennzeichnet, daß die erste und die zweite Stromspiegelschaltung (5, 6) Feldeffekttransistoren eines ersten Leitungstyps und die dritte Stromspiegelschaltung (7) sowie der erste und zweite Mitkopplungszweig (13, 14) sowie der erste und zweite Kopplungszweig (19, 20) Feldeffekttransistoren eines zweiten zu dem ersten entgegengesetzten Leitungstyps aufweisen.

8. Transkonduktanzverstärker nach einem der vorangehenden Ansprüche, dadurch gekennzeichnet, daß die Transistoren der Stromspiegelschaltung (22) des zweiten Kopplungszweiges (20) so dimensioniert sind, daß der Betrag der Ströme (I₄, I₁) des ersten Mitkopplungszweiges (13) und des zweiten Kopplungszweiges (20) in dem Schaltungspunkt (K2) im nicht belasteten Zustand des Ausgangsknotenpunkts A gleich groß ist.

## Claims

1. A CMOS transconductance amplifier with a floating operating point, comprising a voltage-to-current converter having a differential input (1) for an input voltage (u), a current feed point S, to which a quiescent current I₀ is supplied from a constant-current source (2), a first output C, to which a first load element (3) is connected, and a second output B, to which a second load element (4) is connected, the first load element (3) forming the input of a first current mirror circuit (5), the second load element (4) forming the input of a second current mirror circuit (6), and a first output (9) of the first current mirror circuit (5) and a first output (10) of the second current mirror circuit (6) being connected to an output node A such that the output current components (I_{L1}, I_{L2}) combine there in antiphase, and that a second output (11) of the first current mirror circuit (5) and a second output (12) of the second current mirror circuit (6) are respectively connected via a first positive-feedback path (13) and a second positive-feedback path (14) to the current feed point S such that the respective currents (I₁, I₂) of the positive-feedback paths (13, 14) combine positively with the quiescent current (I₀),
characterized in
that the source-drain path of a first transistor (23) is connected in parallel with the first load element (3), and that the source-drain path of a second transistor (24) is connected in parallel with the second load element (4), with the gate terminal of the first transistor (23) connected to the second output B of the voltage-to-current converter, and the gate terminal of the second transistor (24) connected to the first output C of the voltage-to-current converter.

2. A transconductance amplifier as claimed in claim 1, characterized in that each of the load elements (3, 4) comprises a diode-connected load transistor which is of the same type as the first and second transistors (23, 24).

3. A transconductance amplifier as claimed in claim 2, characterized in that the W/L ratio of the first transistor (23) is less than the W/L ratio of the first load transistor (3), and that the W/L ratio of the second transistor (24) is less than the W/L ratio of the second load transistor (4).

4. A transconductance amplifier as claimed in any one of the preceding claims, characterized in that a third output (17) of the first current mirror circuit (5) is connected via a first coupling path (19) with the second output of the second current mirror circuit (6) at a node K1, and a third output (18) of the second current mirror circuit (6) is connected via a second coupling path (20) with the second output (17) of the first current mirror circuit (5) at a node K2, such that the currents of the second positive-feedback path (14) and the first coupling path (19) and those of the first positive-feedback path (13) and the second coupling path (20) combine subtractively.

5. A transconductance amplifier as claimed in any one of the preceding claims, characterized in that the positive-feedback paths (13, 14) and the coupling paths (19, 20) each contain a current mirror circuit.

6. A transconductance amplifier as claimed in any one of the preceding claims, characterized in that the first output (10) of the second current mirror circuit (6) is connected to the output node A via a third current mirror circuit (7).

7. A transconductance amplifier as claimed in any one of the preceding claims, characterized in that the first and second current mirror circuits (5, 6) comprise field-effect transistors of a first conductivity type, and that the third current mirror circuit (7), the first and second positive-feedback paths (13, 14), and the first and second coupling paths (19, 20) comprise field-effect transistors of a second conductivity type which is opposite to the first.

8. A transconductance amplifier as claimed in any one of the preceding claims, characterized in that the transistors of the current mirror circuit (22) of the second coupling path (20) are chosen so that in the unloaded state of output node A, the absolute values of the currents (I₁, I₄) of the first positive-feedback path (13) and the second coupling path (20) at node K2 are equal.

## Revendications

1. Amplificateur de transconductance de type CMOS qui présente un point de fonctionnement dynamique glissant, qui comporte un convertisseur tension/courant qui comporte une entrée différentielle (1) pour une tension d'entrée (U) et un point d'alimentation en courant S sur lequel on envoie un courant de repos (l₀) provenant d'une source de courant constant (S), à la première entrée (C) duquel est relié un premier élément de charge (3) et à la deuxième entrée (B) duquel est relié un deuxième élément de charge (4), amplificateur dans lequel le premier élément de charge (3) constitue l'entrée d'un premier circuit à miroir de courant (5) et !e deuxième élément de charge (4) constitue l'entrée d'un deuxième circuit à miroir de courant (6), dans lequel une première sortie (9) du premier circuit à miroir de courant (5) et une première sortie (10) du deuxième circuit à miroir de courant (6) sont reliées à un point nodal de sortie A de telle manière que, à cet endroit, les deux parties du courant de sortie (I_{L1}, I_{L2}) se superposent avec des phases opposées et dans lequel, d'une part, une deuxième sortie (11) du premier circuit à miroir de courant (5) est reliée au point d'alimentation en courant (S) par l'intermédiaire d'une première branche de réaction (13) et, d'autre part, une deuxième sortie (12) du deuxième circuit à miroir de courant (6) est reliée au point d'alimentation en courant (S) par l'intermédiaire d'une deuxième branche de réaction (14) de telle sorte que chacun des courants (I₁, I₂) des branches de réaction (13, 14) se superpose de manière positive au courant de repos (l₀),
caractérisé en ce que :
le trajet source/drain d'un premier transistor (23) est branché en parallèle sur le premier élément de charge (3) et le trajet source/drain d'un deuxième transistor (24) est branché en parallèle sur le deuxième élément de charge (4), la connexion de porte du premier transistor (23) étant reliée à la deuxième sortie (B) du convertisseur tension/courant et la connexion de porte du deuxième transistor (24) étant reliée à la première sortie (C) du convertisseur tension/courant.

2. Amplificateur de transconductance selon la revendication 1, caractérisé en ce que les éléments de charge (3, 4) comportent chacun un transistor de charge qui est branché en diode et qui est du même type que le premier et le deuxième transistors (23, 24).

3. Amplificateur de transconductance selon la revendication 2, caractérisé en ce que le rapport W/L du premier transistor (23) est plus petit que le rapport W/L du premier transistor de charge (3) et en ce que le rapport W/L du deuxième transistor (24) est plus petit que le rapport W/L du deuxième transistor de charge (4).

4. Amplificateur de transconductance selon l'une quelconque des revendications précédentes, caractérisé en ce que, d'une part, une troisième sortie (17) du premier circuit à miroir de courant (5) est reliée, par l'intermédiaire d'une première branche de couplage (19), à la deuxième sortie (12) du deuxième circuit à miroir de courant (6) en un point de connexion (K1) et, d'autre part, une troisième sortie (18) du deuxième circuit à miroir de courant (6) est reliée, par l'intermédiaire d'une deuxième branche de couplage (20), à la deuxième sortie (11) du premier circuit à miroir de courant (5) en un point de connexion (K2) de telle sorte que les courants de la deuxième branche de réaction (14) et de la première branche de couplage (19), ainsi que les courants de la première branche de réaction (13) et de la deuxième branche de couplage (20) se superposent de manière soustractive.

5. Amplificateur de transconductance selon l'une quelconque des revendications précédentes, caractérisé en ce que les branches de réaction (13, 14) et les branches de couplage (19, 20) comportent chacune un circuit à miroir de courant.

6. Amplificateur de transconductance selon l'une quelconque des revendications précédentes, caractérisé en ce que la première sortie (10) du deuxième circuit à miroir de courant (6) est reliée au pont nodal de sortie A par l'intermédiaire d'un troisième circuit à miroir de courant (7).

7. Amplificateur de transconductance selon l'une quelconque des revendications précédentes, caractérisé en ce que les premier et deuxième circuits à miroir de courant (5, 6) comportent des transistors à effet de champ d'un premier type de conduction et en ce que le troisième circuit à miroir de courant (7) ainsi que les première et deuxième branches de réaction (13, 14) et que les première et deuxième branches de couplage (19, 20) comportent des transistors à effet de champ d'un deuxième type de conduction opposé au premier.

8. Amplificateur de transconductance selon l'une quelconque des revendications précédentes, caractérisé en ce que les transistors du circuit à miroir de courant (22) de la deuxième branche de couplage (20) sont dimensionnés de telle manière que les valeurs des courants (l₁) de la première branche de réaction (13) et (l₄) de la deuxième branche de couplage (20) au point de connexion (K2) sont de même grandeur lorsque le point nodal de sortie (A) est à l'état non chargé et en ce que les transistors du circuit à miroir de courant (21) de la première branche de couplage (19) sont dimensionnés de telle manière que les valeurs des courants (l₂) de la deuxième branche de réaction (14) et (l₃) de la première branche de couplage (19) au point de connexion (K1) sont de même grandeur lorsque le point nodal de sortie (A) est à l'état non chargé.
